# EUROPEAN PATENT APPLICATION

(11) **EP 1 796 174 A1**
(43) Date of publication of application: **13.06.2007**
(21) Application number: 05780953.5
(22) Date of filing: 25.08.2005
(51) Int. Cl.: H01L 29/78, H01L 21/316, H01L 21/318, H01L 21/8234, H01L 27/088, H01L 21/336

(54) **HIGHLY DIELECTRIC FILM, AND UTILIZING THE SAME, FIELD-EFFECT TRANSISTOR AND SEMICONDUCTOR INTEGRATED CIRCUIT APPARATUS, AND PROCESS FOR PRODUCING THE HIGHLY DIELECTRIC FILM**

(30) Priority: 27.08.2004 JP 2004248583
(71) Applicant: Taiyo Nippon Sanso Corporation, Tokyo 142-8558 (JP)
(72) Inventor: KAWAHARA, Takaaki, c/o Renesas Technology Corp., Tokyo 1006334 (JP); TORII, Kazuyoshi, c/o HITACHI, LTD., Tokyo 1008280 (JP); INOUE, Minoru, c/o TAIYO NIPPON SANSO CORPORATION, Tokyo 1428558 (JP); HASAKA, Satoshi, c/o TAIYO NIPPON SANSO CORP., Tokyo 1428558 (JP)
(74) Representative: Smyth, Gyles Darren
(86) International application number: PCT/JP2005/015429
(87) International publication number: WO 2006/022326

(57) **Abstract**

A high-dielectric-constant film including hafnium, wherein the above-mentioned high-dielectric-constant film includes deuterium at a ratio higher than the ratio of deuterium to hydrogen present in nature. In a field-effect transistor provided with the high-dielectric-constant film including hafnium, the interface state density at the interface between a silicon substrate and a gate dielectric film decreases and carrier mobility in the gate dielectric film increases. In the present invention, a high-dielectric-constant constant second dielectric film, which is a thin film including hafnium such as HfSiON or HfAlOₓ and including deuterium at a ratio higher than the ratio of deuterium to hydrogen present in nature, is used as the gate dielectric film of the field-effect transistor.

## Description

### TECHNICAL FIELD

The present invention relates to a high-dielectric-constant film including hafnium, a field-effect transistor (FET) using this high-dielectric-constant film, a semiconductor integrated-circuit device having this field-effect transistor integrated on a substrate, and a method for producing a high-dielectric-constant film.

Priority is claimed on Japanese Patent Application No. 2004-248583, filed August 27, 2004, the content of which is incorporated herein by reference.

### BACKGROUND ART

Conventionally, attempts have been made to realize an improvement in the drive current and a decrease in gate leakage current at the same time by using a high-dielectric-constant film having a relative dielectric constant higher than a silicon oxide film as the gate insulating film of a field-effect transistor and decreasing the equivalent oxide thickness of the gate dielectric film.

Specifically, a combination of a first dielectric film comprising SiO₂ or SiON and a second dielectric film which is formed on top of the above-mentioned first dielectric film and which comprises a high-dielectric-constant film including hafnium such as HfO₂, HfAlOₓ, or HfSiON has been proposed as this type of gate dielectric film.

Also, production of the high-dielectric-constant film including hafnium, which forms the second dielectric film, is carried out by atomic layer deposition, metalorganic chemical vapor deposition, sputtering, or the like. Among these, atomic layer deposition, for which a film having a uniform thickness and composition is obtained, is widely used.

An example of a method for forming a high-dielectric-constant film comprising, for example, HfAlOₓ, by the above-mentioned atomic layer deposition is explained below.

Firstly, a substrate is placed in a reaction chamber and the above-mentioned reaction chamber is evacuated to vacuum. Next, tetrakis (ethylmethylamino) hafnium (TEMAHf), as a hafnium source, is fed into the above-mentioned reaction chamber for a short time and after this, excess TEMAHf are removed from the above-mentioned reaction chamber by purging. Next, water, as an oxidizing agent, is fed into the above-mentioned reaction chamber for a short time and after this, excess water are removed from the above-mentioned reaction chamber by purging. Furthermore, after trimethylaluminum (TrMA), as an aluminum source, is fed into the above-mentioned reaction chamber for a short time, excess TrMA are removed by purging.

After this, water, as an oxidizing agent, is again fed into the above-mentioned reaction chamber for a short time and excess water are purged. The hafnium source, aluminum source, and oxidizing agent are fed into the above-mentioned reaction chamber by a carrier gas such as argon. In these operations, the reaction progresses by heating the above-mentioned substrate to approximately 300°C. Also, a dielectric film comprising HfAlOₓ and which has a predetermined thickness is obtained by repeating this set of operations a number of times.

However, in a field-effect transistor provided with this type of high-dielectric-constant film including hafnium as a gate dielectric film, there are the problems that the defect density and interface state density at the interface between the silicon substrate and the gate dielectric film are high. There was thus the weakness that the mobility and long-term reliability of the carrier in the gate dielectric film were inferior compared to thermally oxidized silicon films.

A technique of decreasing hot carrier degradation by including deuterium in a silicon substrate and a gate dielectric film comprising silicon dioxide is disclosed in United States Patent No. 6,143,632.

Also, a technique for preventing the accumulation at trap sites of a hot carrier which increases charge trapped in the gate dielectric layer so a device does not degrade by forming a gate dielectric film comprising silicon dioxide on top of a silicon substrate by thermal oxidation and including deuterium in the trap sites of the above-mentioned gate dielectric film, is disclosed in United States Patent No. 6,187,665.

Improvement in the performance of a field-effect transistor by including deuterium in a gate dielectric film comprising silicon dioxide is thus well known.
Patent Document 1: United States Patent No. 6,143,632
Patent Document 2: United States Patent No. 6,187,665

### DISCLOSURE OF THE INVENTION

The problems of the present invention are decreasing the interface state density at the interface between a silicon substrate and a gate dielectric film as well as increasing carrier mobility in the gate dielectric film of a field-effect transistor provided with a gate dielectric film comprising a high-dielectric-constant film including hafnium.

In order to solve these problems,
(1) The present invention is a high-dielectric-constant film including hafnium, wherein the above-mentioned high-dielectric-constant film includes deuterium at a ratio higher than the ratio of deuterium to hydrogen present in nature.
(2) The present invention is the high-dielectric-constant film recited in the above-mentioned (1), wherein the high-dielectric-constant film including hafnium comprises hafnium-silicon-oxynitride (HfSiON), hafnium-aluminate (HfAlOₓ), hafnium nitride-aluminate (HfAlON), hafnium-oxide (HfO₂), or hafnium-silicon-oxide (HfSiOₓ).
(3) The present invention is a field-effect transistor comprising: a semiconductor substrate provided with a source region and a drain region separated; and a gate dielectric film including a high-dielectric-constant film comprising at least hafnium on top of said semiconductor substrate, wherein the gate dielectric film comprising a high-dielectric-constant film including hafnium includes deuterium and the ratio of the deuterium included is 0.05 to 50%, which is higher than the ratio of deuterium to hydrogen of 0.005% present in nature.
(4) The present invention is the field-effect transistor recited in the above-mentioned (3), wherein a silicon oxide film or a silicon-oxynitride film is provided between the above-mentioned semiconductor substrate and the above-mentioned gate dielectric film comprising a high-dielectric-constant film including hafnium.
(5) The present invention is a semiconductor integrated circuit device, wherein the field-effect transistor recited in the above-mentioned (3) or (4) is integrated on the above-mentioned semiconductor substrate.
(6) The present invention is a method for producing a high-dielectric-constant film, comprising the successive steps of : (a) Evacuating a reaction chamber in which a substrate is placed to predetermined pressure, (b) introducing at least one raw material compound into the reaction chamber and adsorbing the raw material compound onto a surface of the substrate, (c) removing excess raw material compound from the reaction chamber, (d) introducing an oxidizing agent into the reaction chamber and oxidizing the raw material compound adsorbed onto the substrate, and (e) removing excess oxidizing agent from the reaction chamber, wherein the step (a) to the step (e) are repeated, the at least one raw material compound is one or more types of compounds including hafnium and the at least one raw material compound is introduced into the reaction chamber sequentially for each type in the step (b), and the oxidizing agent is heavy water.
(7) The present invention is a method for producing a high-dielectric-constant film comprising the successive steps of : (a) Evacuating a reaction chamber in which a substrate is placed to predetermined pressure, (b) introducing at least one raw material compound into the reaction chamber and adsorbing the raw material compound onto a surface of the substrate, (c) removing excess raw material compound from the reaction chamber, (d) introducing an oxidizing agent into the reaction chamber and oxidizing the raw material compound adsorbed onto the substrate, and (e) removing excess oxidizing agent from the reaction chamber, wherein the step (a) to the step (e) are repeated, the at least one raw material compound is one or more types of compounds including hafnium and the at least one raw material compound is introduced into the reaction chamber sequentially for each type in the step (b), and a combination of deuterium and oxygen, or a combination of deuterium and ozone are used as the above-mentioned oxidizing agent.
(8) The present invention is the method for producing a high-dielectric-constant film according to the above-mentioned (6) or (7), wherein the total amount of metallic impurities included in the above-mentioned heavy water or deuterium is less than or equal to 1 wtppm.

According to the present invention, in a field-effect transistor provided with a gate dielectric film comprising a high-dielectric-constant film including hafnium, interface state density at the interface between the silicon substrate and the gate dielectric film can be decreased, carrier mobility in the gate dielectric film can be increased, and performance of the field-effect transistor can be improved.

### BRIEF DESCRIPTION OF THE DRAWINGS

Fig. 1 is a schematic cross-sectional view showing an example of a semiconductor integrated-circuit device of the present invention.
Fig. 2 is a schematic explanatory diagram showing a production step of a semiconductor integrated-circuit device of the present invention.
Fig. 3 is a schematic explanatory diagram showing a production step of a semiconductor integrated-circuit device of the present invention.
Fig. 4 is a schematic explanatory diagram showing a production step of a semiconductor integrated-circuit device of the present invention.
Fig. 5 is a schematic explanatory diagram showing a production step of a semiconductor integrated-circuit device of the present invention.
Fig. 6 is a schematic explanatory diagram showing a production step of a semiconductor integrated-circuit device of the present invention.
Fig. 7 is a schematic explanatory diagram showing a production step of a semiconductor integrated-circuit device of the present invention.
Fig. 8 is a graph showing an effect of the present invention by comparing interface state density.
Fig. 9 is a graph showing an effect of the present invention by comparing interface state density measured by charge pumping.
Fig. 10 is a graph showing an effect of the present invention by comparing mobility.
Fig. 11 is a graph showing an effect of the present invention by comparing mobility.

### DESCRIPTION OF SYMBOLS

1... silicon layer, 2... diffused layer, 4... element isolated region, 6... first dielectric film, 8... second dielectric film, 10... gate electrode, 12... side wall

### BEST MODE FOR CARRYING OUT THE INVENTION

The present invention is explained in detail below.

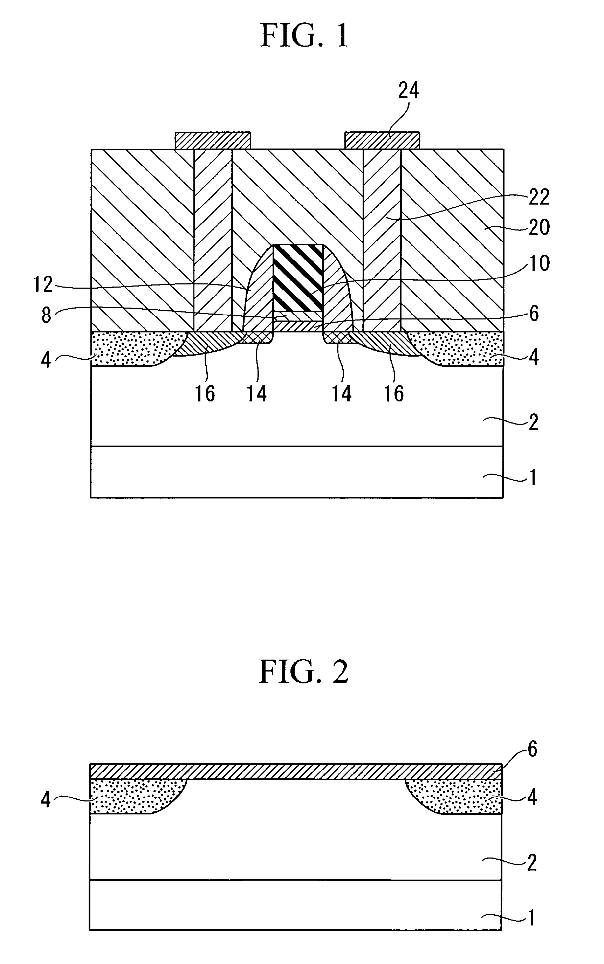

Fig. 1 shows an example of a semiconductor integrated-circuit device of the present invention. Reference numeral 1 in the figures represents a silicon substrate. Dopants are implanted into the above-mentioned silicon substrate 1 and a diffused layer 2 is formed. A gate dielectric film comprising a first dielectric film 6 and a second dielectric film 8 on top of the above-mentioned first dielectric film 6 is formed in a region separated by an element isolation region 4 of the above-mentioned silicon substrate 1.

The above-mentioned first dielectric film 6 is a thin film having a thickness of less than or equal to 1 nm formed from, for example, SiO₂, SiON, or the like, and functions as an interface dielectric film.

Also, the above-mentioned second dielectric film 8 is a thin film having a thickness of 1.5 to 3 nm including hafnium such as, for example, HfO₂, HfSiON, or HfAlOₓ, and shows a high dielectric constant.

A gate electrode 10 comprising polysilicon is formed on top of the above-mentioned gate dielectric film.

Sidewalls 12 are formed on side surfaces of the above-mentioned gate electrode 10. The above-mentioned sidewalls 12 are formed from Si₃N₄ or the like.

SD extensions 14, which are diffused layers having comparatively low dopant concentrations, are formed further on the outside than the above-mentioned gate electrode 10 on the surface of the above-mentioned silicon substrate 1. Also, a source/drain 16, which are diffused layers having comparatively deep bonding depths and high dopant concentrations, are formed further on the outside than the above-mentioned SD extensions 14 near the surface of the above-mentioned silicon substrate 1 and further on the outside than the above-mentioned sidewalls 12.

Furthermore, interlayer dielectric films 20 are deposited on top of the above-mentioned silicon substrate 1 so that the above-mentioned gate electrode 10, the above-mentioned sidewalls 12, and the like are embedded. Also, contact plugs 22, which pass through the above-mentioned interlayer dielectric films 20 to the above-mentioned source/drain 16, are formed on the above-mentioned interlayer dielectric films 20 and wiring layers 24 are provided on top of the above-mentioned contact plugs 22.

Also, in this example, deuterium is included in the high-dielectric-constant film including hafnium which forms the above-mentioned second dielectric film 8. The above-mentioned deuterium is included at a ratio, for example, 0.05 to 50%, which is larger than the ratio of deuterium to hydrogen of 0.005% present in nature. Also, the above-mentioned deuterium is in a state in which a part of the hydrogens bonded in the form of hydroxyl groups to the hafnium, silicon, or aluminum which forms the above-mentioned thin film is replaced with deuterium. A part of the above-mentioned deuterium is diffused on the substrate side by heat treatment in a process which forms a transistor and silicon dangling bonds present at the interface between the silicon substrate 1 and the first dielectric film 6 are terminated.

Next, a production example of this type of semiconductor integrated-circuit device is explained. Here, formation of the second dielectric layer 8, which forms the gate dielectric layer, by well-known atomic layer deposition is explained. Firstly, the element isolation region 4 is formed on top of the silicon substrate 1 having a diffused layer 2 formed by the implanting of dopants and furthermore, the surface of the silicon substrate 1 separated to each region is washed using diluted hydrofluoric acid. After the treatment with diluted hydrofluoric acid, as shown in Fig. 2, a SiON film, which becomes the first dielectric layer 1, is formed on top of the silicon substrate 1. Here, although the SiON film is formed using H₂ or D₂ and N₂O, the film may be formed by a method such as plasma nitridation of a thermally-oxidized film or reoxidation of a thermally-nitridated film.

Next, the second dielectric film 8 is formed on top of the above-mentioned first dielectric film 6. The silicon substrate 1, on which the first dielectric film 6 is formed, is placed in a reaction chamber and the reaction chamber is evacuated to vacuum. Next, tetrakis (ethylmethylamino) hafnium (TEMAHf) is fed into the reaction chamber for 1 to 2 seconds.

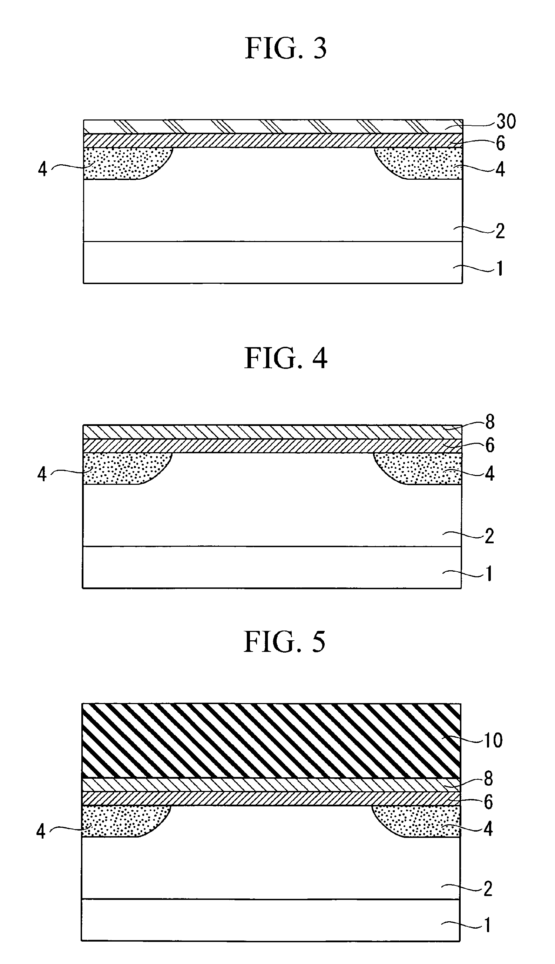

As shown in Fig. 3, a monomolecular layer 30 of tetrakis (ethylmethylamino) hafnium (TEMAHf) is thus formed on the surface of the first dielectric film 6 of the substrate 1 by chemical adsorption. Next, excess TEMAHf are removed by purging the reaction chamber.

Next, after heavy water, as an oxidizing agent, is fed into the reaction chamber for 0.1 to 0.3 seconds, excess heavy water are removed from the reaction chamber by purging. Next, after feeding an active species into the reaction chamber by generating a NH₃/Ar plasma, the reaction chamber is purged. After this, tetramethylaluminum (TeMA) is fed into the reaction chamber for no more than 1 second and the reaction chamber is purged. Next, heavy water is again fed for 0.1 to 0.3 seconds. After this, excess heavy water are removed by purging from the reaction chamber.

As shown in Fig. 4, the second dielectric film 8 comprising HfAlOₓ and having a high dielectric constant is formed by repeating the above-mentioned set of operations a number of times.

Approximately 0.2 at% of deuterium is included in the above-mentioned second dielectric film 8. Next, heat treatment is carried out in a diluted oxygen atmosphere and the second dielectric film 8 is densified. Here, a rapid heat treatment is carried out in a 0.2 % diluted oxygen atmosphere for 1 second at 1000°C. After the heat treatment, extremely 0.01 at% deuterium is present near the substrate interface and the ratio of deuterium to hydrogen is 6%.

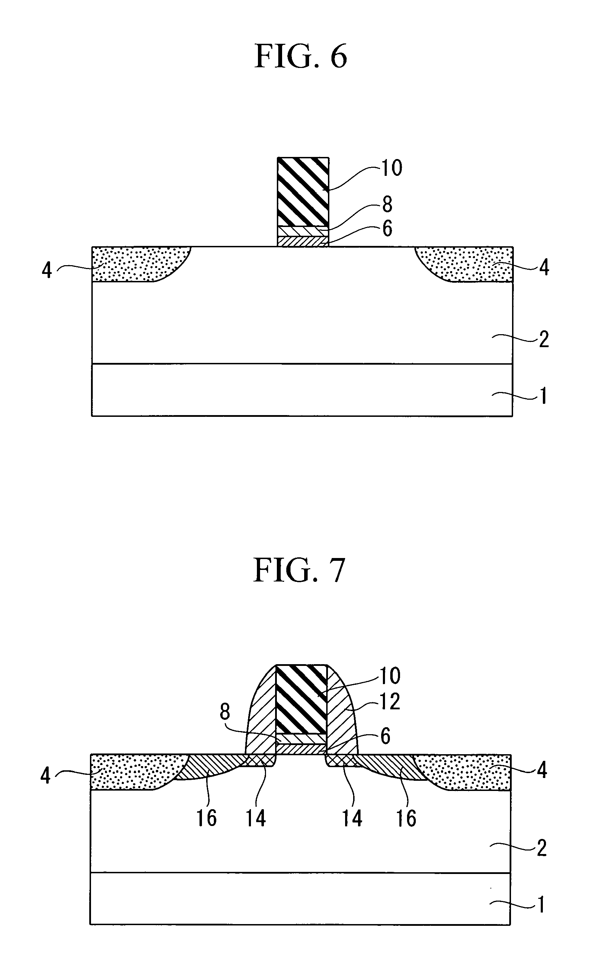

Next, as shown in Fig. 5, a polysilicon film, which becomes the above-mentioned gate electrode 10, is deposited on top of the above-mentioned second dielectric film 8 by chemical vapor deposition. After gate impurities are implanted into the polysilicon film using a well-known photolithographic method and an ion implantation method, as shown in Fig. 6, the above-mentioned polysilicon film is processed into a predetermined shape by etching to give the above-mentioned gate electrode 10. When doing so, the above-mentioned second dielectric film 8 and the above-mentioned first dielectric film 6 are also etched and the above-mentioned first dielectric film 6 and the above-mentioned second dielectric film 8 are processed to the same width as the gate electrode 10.

After this, ion implantation is carried out with the above-mentioned gate electrode 10 as a mask and SD extensions 14, which are diffused layers having comparatively shallow bonding depths, are formed.

Next, as shown in Fig. 7, sidewalls 12 are formed on side surfaces of the above-mentioned gate electrode 10. The above-mentioned sidewalls 12 are formed by leaving a SiN film only on the side surfaces of the above-mentioned gate electrode 10 by etching after depositing the SiN film or the like so that the above-mentioned gate electrode 10 is embedded.
Next, ion implantation is carried out with the above-mentioned gate electrode 10 and the above-mentioned sidewalls 12 as masks and the source/drain 16, which are diffused films having high dopant concentrations, are formed on the surface of the above-mentioned silicon substrate 1. After this, activated annealing is carried out in order to activate the ion implanted impurities.

After this, interlayer dielectric films 20 are formed on top of the silicon substrate 1 by embedding the above-mentioned gate electrode 10, the above-mentioned sidewalls 12, and the like. Furthermore, after forming contact plugs 22 on the above-mentioned interlayer dielectric films 20 through to the drain/source 16, by forming wiring layers 24 on top of this, a semiconductor integrated- circuit device having the structure shown in Fig. 1 can be obtained.

When forming the above-mentioned second dielectric film 8 by atomic layer deposition in this production method, other than TEMAHf, as the hafnium source, HFCl₄, Hf[OC(CH₃)₂CH₂OCH₃] ₄, Hf[OC(CH₃)₃]₄, Hf[N(CH₃)₂]₄, Hf[N(C₂H₅)₂]₄, Hf(NO₃)₄, Hf(C₁₁H₁₉O₂)₄, or the like can be used. Also, other than TrMA, as the aluminum source, TEA (triethylaluminum, Al(C₂H₅)₃), DMAH (dimethylaluminum hydride, Al(CH₃)₂H), DMEAAl (dimethylethyl amine:alane, AlH₃:N(CH₃)₂C₂H₅), or the like can be used.

In the present embodiment, a NH₃/Ar plasma pulse is added in the atomic layer deposition cycle. Thus, 3 to 5% of nitrogen is included in a high-dielectric-constant film. The NH₃/Ar plasma pulse reduces residual impurities in the high-dielectric-constant film and also has the effect of repairing electrical defects associated with the oxygen vacancies by the addition of the nitrogen. Thus, although this is effective in increasing the reliability of the high-dielectric-constant film, a HfAlOₓ film not including nitrogen can also be used without the NH₃/AR plasma pulse. Also, after production of the HfAlOₓ film, nitrogen may be added by a method such as NH₃ annealing to give a HfALON film.

Also, when a HFO₂ film is formed as the above-mentioned second dielectric film 8, a step for introducing TrMA is unnecessary. Furthermore, when a HfSiOₓ film is formed as the above-mentioned second dielectric film 8, instead of TrMA, an amine silicon raw material such as tetrakis-ethylmethylamino-silane or tris-diethylamino-silane, is introduced as the silicon source. Also, when a HfSiON film is formed as the above-mentioned second dielectric film 8, after adding an amine silicon raw material such as tetrakis-ethylmethylamino-silane or tris-diethylamino-silane as the silicon source instead of TrMA and forming the HfSiOₓ film, nitrogen can be introduced by a method such as ammonia heat treatment or plasma nitridation.

Also, other than heavy water, as the above-mentioned oxidizing agent, a combination of deuterium and oxygen or a combination of deuterium and ozone can be used. In these combinations, it is preferable that the mixed ratio of deuterium is 1 to 50 vol%.

It is preferable that the total amount of metallic impurities such as iron and copper included in the heavy water or deuterium used here is less than or equal to 1 wtppm. If the amount of included metallic impurities becomes larger than this, leakage current of the second dielectric film 8 increases and there is the danger that a long-term reliability problem such as decreasing the lifetime of TDDB (time dependent dielectric breakdown) will occur.

Also, when the number of defects at the interface between the above-mentioned silicon substrate and the above-mentioned gate dielectric film have increased if the total amount of metallic impurities such as iron and copper included in the above-mentioned heavy water or the above-mentioned deuterium is less than 10 wtppb, the interface state density at the above-mentioned interface decreases and long-term reliability is improved. A small amount of light water may be mixed in the heavy water and a small amount of hydrogen may be mixed in the deuterium.

Furthermore, when forming the above-mentioned second dielectric film 8, it is not always necessary to use a NH₃/Ar plasma. Also, other than the above-mentioned atomic layer deposition, metalorganic chemical vapor deposition can be used to form the above-mentioned second insulating film 8.

Furthermore, as the method of including the above-mentioned deuterium in the above-mentioned second dielectric layer 8, carrying out annealing in a deuterium atmosphere at 400 to 600°C for extremely 30 minutes not when forming the above-mentioned second dielectric film 8 but after the above-mentioned activated annealing step in the set of production steps for the integrated-circuit device is also possible.

In this type of semiconductor integrated-circuit device, the above-mentioned deuterium is included in the above-mentioned second dielectric film 8 of the field-effect transistor, which forms the semiconductor integrated device, the above-mentioned deuterium functions as the source of deuterium fed to the silicon substrate interface, and the majority of silicon dangling bonds at the above-mentioned substrate interface are terminated by deuterium. Deuterium has approximately twice the mass of hydrogen. Thus, an increase (become dangling bonds by the hydrogen terminations coming off) of the interface state by heat treatment and electrical stress is difficult to occur for silicon dangling bonds terminated by deuterium compared to silicon dangling bonds terminated by hydrogen.

Thus, the interface state density of the interface between the above-mentioned silicon substrate and the above-mentioned gate dielectric film decreases and long-term reliability is also improved.

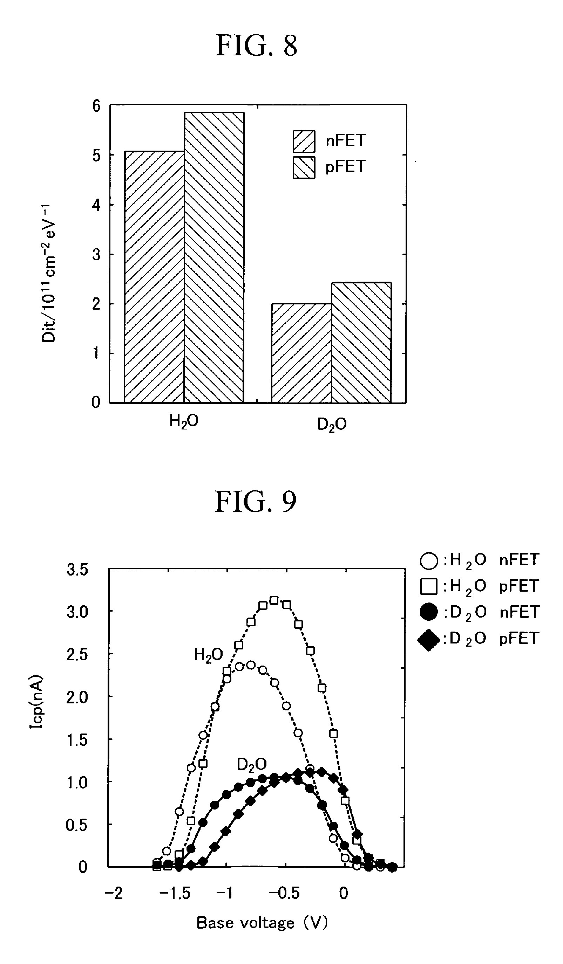

Fig 8 represents the comparison of the measured interface state density for a HfAlOₓ film formed by the above-mentioned atomic layer deposition using heavy water as the oxidizing agent and a HfAlOₓ film formed using water as the oxidizing agent under the same conditions.

Also, Fig. 9 is similarly the comparison of the interface state density measured by charge pumping method for a HfAlOₓ film formed by the above-mentioned atomic layer deposition using heavy water as the oxidizing agent and a HfAlOₓ film formed using water as the oxidizing agent under the same conditions.

From these graphs, it is clear that the interface state density is reduced to an arrange of 1/2 to 1/3 for the HfAlOₓ film including deuterium compared to the conventional HfAlOₓ film not including deuterium.

Thus, the negative bias temperature instability (NBTI) of a p-type transistor when adding a high temperature negative bias is improved. The threshold voltage shift when stress was applied at 125°C became 1/1.4. Also, the time dependent dielectric breakdown (TDDB) lifetime when a gate negative bias was applied improved by ten times or more.

Also, the carrier mobility of the transistor is improved as an effect of reducing the interface state density.

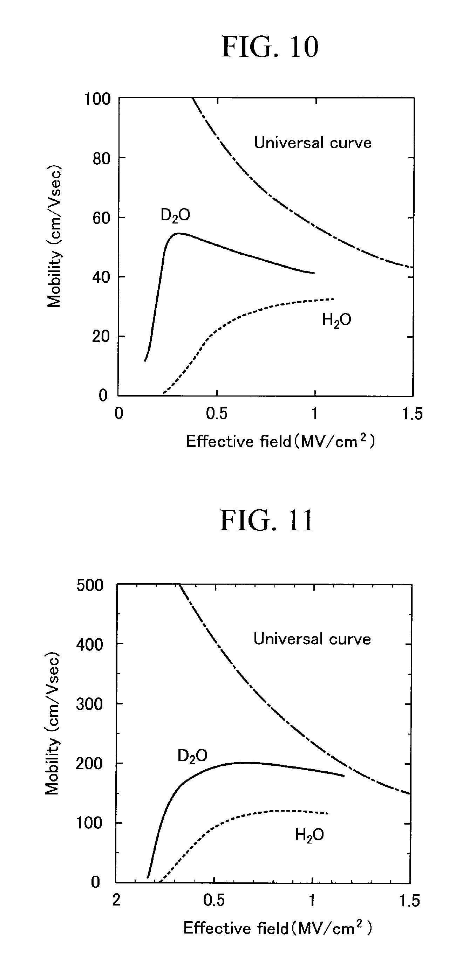

Fig. 10 and Fig. 11 represent the comparison of the measured mobility for a HfAlOₓ film formed by the above-mentioned atomic layer deposition using heavy water as the oxidizing agent and a HfAlOₓ film formed using water as the oxidizing agent under the same conditions.

From these graphs, it is understood that the mobility of the gate dielectric film comprising a HfAlOₓ film including deuterium, compared to the conventional HfAlOₓ film not including deuterium, can be improved up to extremely two times.

By the production method of the present invention for a HfAlOₓ film using heavy water, although the average deposition speed thereof is reduced to approximately 90% compared to a film formed using water, it is clear that the distribution on the substrate surface of the amount of HfAlOₓ film adhering to the silicon substrate is, similar to the HfAlOₓ film formed using water, homogeneous.

### INDUSTRIAL APPLICABILITY

According to the high-dielectric-constant film of the present invention, interface state density of a interface between a silicon substrate and a gate dielectric film can be decreased and carrier mobility in the gate dielectric film can be increased. It is thus possible to offer a superior field-effect transistor (FET) using the high-dielectric-constant film and semiconductor integrated-circuit device having a field-effect transistor integrated on the substrate, the industrial significance thereof being very large.

## Claims

1. A high-dielectric-constant film comprising hafnium, wherein
the high-dielectric-constant film includes deuterium at a ratio higher than the ratio of deuterium to hydrogen present in nature.

2. The high-dielectric-constant film according to claim 1, wherein
the high-dielectric-constant film comprising hafnium includes hafnium silicon oxynitride (HfSiON), hafnium aluminate (HfAlOₓ), hafnium nitride aluminate (HfAlON), hafnium oxide (HfO₂), or hafnium silicon oxide (HfSiOₓ).

3. A field-effect transistor comprising:
a semiconductor substrate provided with a source region and a drain region separated; and
a gate dielectric film including a high-dielectric-constant film comprising at least hafnium on top of said semiconductor substrate, wherein
the gate insulating film comprising a high-dielectric-constant film including hafnium includes deuterium and
the ratio of the deuterium included is 0.05 to 50%, which is higher than the ratio of deuterium to hydrogen of 0.005% present in nature.

4. The field-effect transistor according to claim 3, wherein
a silicon oxide film or a silicon oxynitride film is provided between the semiconductor substrate and the gate dielectric film comprising a high-dielectric-constant film including hafnium.

5. A semiconductor integrated-circuit device, wherein
the field-effect transistor according to claim 3 or 4 is integrated on the semiconductor substrate.

6. A method for producing a high-dielectric-constant film, comprising the successive steps of :
(a) Evacuating a reaction chamber in which a substrate is placed to predetermined pressure,
(b) introducing at least one raw material compound into the reaction chamber and adsorbing the raw material compound onto a surface of the substrate,
(c) removing excess raw material compound from the reaction chamber,
(d) introducing an oxidizing agent into the reaction chamber and oxidizing the raw material compound adsorbed onto the substrate, and
(e) removing excess oxidizing agent from the reaction chamber, wherein
the step (a) to the step (e) are repeated,
the at least one raw material compound is one or more types of compounds including hafnium and the at least one raw material compound is introduced into the reaction chamber sequentially for each type in the step (b), and
the oxidizing agent is heavy water.

7. A method for producing a high-dielectric-constant film comprising the successive steps of :
(a) Evacuating a reaction chamber in which a substrate is placed to predetermined pressure,
(b) introducing at least one raw material compound into the reaction chamber and adsorbing the raw material compound onto a surface of the substrate,
(c) removing excess raw material compound from the reaction chamber,
(d) introducing an oxidizing agent into the reaction chamber and oxidizing the raw material compound adsorbed onto the substrate, and
(e) removing excess oxidizing agent from the reaction chamber, wherein
the step (a) to the step (e) are repeated,
the at least one raw material compound is one or more types of compounds including hafnium and the at least one raw material compound is introduced into the reaction chamber sequentially for each type in the step (b), and
a combination of deuterium and oxygen, or a combination of deuterium and ozone are used as the oxidizing agent.

8. The method for producing a high-dielectric-constant film according to claim 6 or 7, wherein the total amount of metallic impurities included in the heavy water or deuterium is less than or equal to 1 wtppm.
